# EUROPEAN PATENT APPLICATION

(11) **EP 2 148 434 A1**
(43) Date of publication of application: **27.01.2010**
(21) Application number: 08104871.2
(22) Date of filing: 24.07.2008
(51) Int. Cl.: H03F 1/52, H03F 1/56

(54) **Radio frequency circuit with electrostatic protection and impedance matching and method for calibrating the same**

(71) Applicant: Seiko Epson Corporation, Shinjuku-ku Tokyo 163-0811 (JP)
(72) Inventor: Mateo, Diego c/o Departament d'Enginyeria Electronica, Jordi Girona 1-3 08034 Barcelona (ES); González, José Luis c/o Departament d'Enginyeria Electronica, Jordi Girona 1-3 08034 Barcelona (ES); Aragonès, Xavier c/o Departament d'Enginyeria Electronica, Jordi Girona 1-3 08034 Barcelona (ES); Berenguer, Roc c/o Centro de Estudios e Investigaciones, 20018 Donostia-San Sebastian (ES); Adin, Iñigo c/o Centro de Estudios e Investigaciones, 20018 Donostia-San Sebastian (ES); Galí, Ignacio Gil c/o EPSON EUROPE ELECTRONICS GmbH, Modil C 2a planta 08190 San Cugat del Vallès Barcelona (ES); Cairo Molins, Josep Ignasi c/o EPSON EUROPE ELECTRONICS GmbH, Modil C 2a planta 08190 San Cugat del Vallès Barcelona (ES); Tanaka, Kazuaki c/o EPSON EUROPE ELECTRONICS GmbH, Modil C 2a planta 08190 San Cugat del Vallès Barcelona (ES)
(74) Representative: Carpintero Lopez, Francisco

(57) **Abstract**

Radio frequency (RF) circuit comprising a power rail ESD clamp circuit (1), a RF input (2), an inductor (3) from an LNA input (100) and a diodes structure for ESD protection and input impedance matching, which in turn comprises: a first ESD diodes structure (10) including a first diode (11) and an additional four-diode structure (4') having a mid point which a biasing voltage (200) is applied to, and a second ESD diodes structure (20) forming together with the first diodes structure (10) a Pi-matching network to match the 50Ω RF input (2) with the LNA input (100) of the RF circuit. The DC biasing voltage (200) on the ESD diodes is changed for calibration of this matching network connected to the LNA input (100).

## Description

### Technical field of the invention

The present invention relates to a RF circuit used to match to the reference impedance (typically 50Ω), the input section of the LNA (low noise amplifier) by adjusting the effective capacitance of the ESD (electrostatic discharge) diodes using a biasing voltage.

Moreover, this technique can be applied to compensate the process variations effects on the input impedance of the LNA where a good matching to the antenna is required.

### State of the Art

The low noise amplifier (LNA) is commonly connected to the RF (Radio Frequency) signal input pad through a matching network that adapts the LNA input impedance to the reference impedance. The adjustment of the input matching network is done for the frequency band of operation and optimizes the signal power transference to the RF front-end. Due to process dispersions and variability, the adjustment of the matching network is modified and it may cause important performance degradation from its ideal value.

Part of the variations in the behavior of the LNA is caused by improper matching. When an input frequency matching is artificially forced, the variability of the performance of the LNA is very much reduced.

The main sources of process variations in the LNA are, on the one hand, the behavior of transistors and the biasing voltage, and on the other hand, the variations of passive components like on-chip inductors and capacitors.

Process variability and calibration of RF circuits has become recently a much researched topic due to technology advances and increase of variability. Several references in literature propose different approaches for sensing the variability, performing calibration and assuring reliability of RF circuits. The majority of attempts addressing this topic use self-test techniques and require important processing overheads or notable off-chip computation. Regarding the sensing methods, most approaches select the less intrusive way for quantifying performance, which is current sensing with a tiny resistor placed on the drain or source of a LNA.

Different techniques to re-calibrate input matching can be found in the literature, based almost on a switchable inductor. Such approach could be very effective but not in the RF front-end under consideration. Moreover, in case of very low power consumption circuitry many characteristics are under high pressure to fulfill the specifications and the implementation of such switchable inductor could worsen many of them. Besides, this technique (switchable inductor) is not effective from the area point of view.

### Description of the invention

The present invention describes a novel architecture and method that calibrate the input matching frequency by using a control voltage over the ESD diode structure included in the input matching network. This approach tests the input match frequency by using a built-in self-test (BiST) structure and progressively corrects the input matching by adjusting a control bias voltage applied to the ESD diodes.

The main advantages of the present approach are more flexibility and simplicity in self-calibrating of integrated RF front-end circuits, since it involves less circuitry than the existing approaches based on switchable inductors. Furthermore, varying the control voltage of the ESD diodes (and consequently their capacitance) results more convenient than switching parts of an inductor.

The here described invention can be used to calibrate the input section of a low noise amplifier (LNA) and may also be used at the output section of the Power Amplifier (PA), by adjusting the effective capacitance of their ESD diodes using a biasing voltage, in order to compensate the process variations effects on the output inductor of the PA, where a good matching is required to the RF antenna.

In the electronic architecture proposed here, a matching network (e.g., a typical "L" section, a Pi network, etc.) is used to adapt the input impedance of the LNA to the reference impedance (typically 50 Ohms). The architecture used in the present invention integrates ESD diodes and takes profit of its capacitance to generate the appropriate matching.

Additionally this proposal allows compensating the RF front-end against fabrication process-induced variations on the gate inductor of the LNA and variations of gate-source capacitance of its amplifying transistor. In contrast to the solutions based on a switchable inductor, a better way to actuate for input matching calibration is to take advantage of the input matching network that includes ESD diodes, and use these components for the actuation part of the calibration scheme.

The present approach is based on a structure of four ESD diodes biased by a control variable DC voltage. Since the ESD diodes present an equivalent capacitance that depends on the DC voltage applied to them, an internally generated bias voltage, adjusted in the factory after a calibration test, can be used to tune this capacitance value and compensate the drift of other components of the RF front-end circuit.

An aspect of the invention is a method for calibrating a RF circuit which comprises the use of a variable control voltage introduced on ESD circuitry that is an internally generated bias voltage used to tune the capacitance value of the equivalent capacitance of the diodes.

It is not an object of the present invention the sensing and generation of control signals that could be designed following common structures found in the literature.

Another aspect of the invention refers to a RF integrated circuit adapted to be connected to an LNA and comprising:
- a RF input section which a RF input signal is injected to,
- an input inductor (due to the gate of the LNA) connected to the LNA input,
- a power rail ESD clamp circuit, between the power supply voltage (Vcc) and ground, for improving the ESD protection of the RF circuit, and
- a circuit structure of ESD diodes which serves as ESD protection circuit and as input matching network, to which a biasing voltage is applied in order to tune the capacitance value of the equivalent capacitance of the ESD diodes, so that any of these goals is achieved:
   - simultaneous protection against ESD events and matching of the LNA input to the antenna impedance,
   - compensation of process-induced variations in the input matching network of the LNA,
   - implementation of integrated input-transformation PI-networks using inductors and diodes with adjustable capabilities for tuning or process-induced variations compensation in RF integrated circuits.

The same RF integrated circuit can be adapted to be connected at the input or output of a Power Amplifier (PA) achieving the same goals:
- simultaneous protection against ESD events and matching of the PA input or output to the antenna impedance,
- compensation of process-induced variations in the input or output matching network of the PA,
- implementation of integrated input or output transformation PI networks using inductors and diodes with adjustable capabilities for tuning or process-induced variations compensation in RF integrated circuits.

### Brief description of the drawings

To complete the description and in order to provide a better understanding of the invention, a set of drawings are presented. Said drawings form an integral part of the description and illustrate preferred embodiments of the invention, which should not be interpreted as restricting the scope of the invention, but just as examples of how the invention can be embodied. The drawings comprise the following figures:
Figure 1 - Shows a RF front end circuit including a four-diode structure that together with the input inductor provides ESD protection and impedance matching of the LNA.
Figure 2 - Shows a simplified equivalent circuit of the Pi-matching network composed by the four ESD diodes illustrated in the previous figure and the input inductor.
Figure 3 - Shows a graphical representation of S11 parameter measurements obtained by simulations wherein the input inductor of the LNA experiences changes of ±10% from a typical value of said inductor L = 9.1 nH.
Figure 4 - Shows a circuit structure of a modified matching network including parasitic diodes between biasing control point and ground, according to a preferred embodiment of the present invention.
Figure 5 - Shows a graphical representation of S21 and S11 parameter measurements obtained by simulations for typical (L = 9.1 nH), maximum (L = 10.01 nH) and minimum (L = 8.19 nH) values of the LNA input inductor, after the proposed compensation method is applied.

### Preferred embodiment of the invention

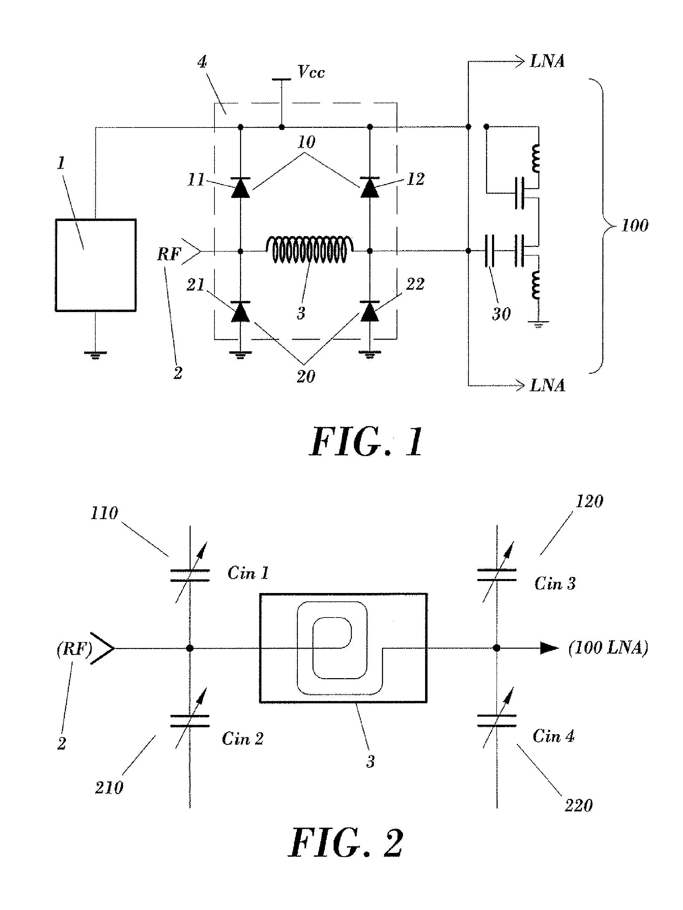

A practical implementation of the invention is described, as can be shown in Figure 1, proposing integrated circuit architecture for electrostatic discharge protection and impedance matching of RF circuits which comprises:
- a power rail ESD clamp circuit (1),
- a RF input section (2),
- an input inductor (3),
- a four-diode structure (4) in turn comprising:
   - a first diodes structure (10) which is an ESD protection structure, including a first diode (11) and a second diode (12); and
   - a second diodes structure (20), including a third diode (21) and a fourth diode (22) which perform ESD protection too, the second diode structure (20) forming together with the first diode structure (10) and the input inductor (3), an input matching network structure, in this case a Pi-matching network.

The four-diode structure (4), formed by these first and second diodes structures (10, 20) together with the input inductor (3), configures in the illustrated example a Pi-matching network to match the 50Ω input impedance of the RF input section (2) with the LNA input (100) impedance.

Additionally, a blocking capacitor (30) is required to be connected between the matching network and the LNA input (100) when a DC control voltage for tuning the equivalent capacitance of the ESD diodes structure is applied. This way the bias of the LNA is not affected by the DC control voltage.

The input resonance frequency and input impedance seen by the antenna depends on the size of the four ESD diodes (11, 12, 21, 22) and the input inductor (3), as well as on the input impedance of the active section of the LNA, which is connected at the output of the PI-matching network.

Since process variations can modify the expected electrical value of the capacitance and inductance of any of such components, a calibration mechanism is necessary if the process variation impact makes the circuit going out of specifications.

The calibration method comprises the variation of the equivalent capacitance of the diodes (11, 12, 21, 22), shown in Figure 2, wherein the first diodes structure (10) comprises its equivalent capacitors, Cᵢₙ₁ (110) corresponding to the first diode (11) and Cᵢₙ₃ (120) which corresponds to the second diode (12), and wherein also the second diodes structure (20) comprises its equivalent capacitors, Cᵢₙ₂ (210) for the third diode (21) and Cᵢₙ₄ (220) for the fourth diode (22). The capacitance of the aforementioned diodes depends on the DC voltage applied between their terminals; therefore internally generated control bias voltage can be used to tune this capacitance value and provides a drift compensation effect.

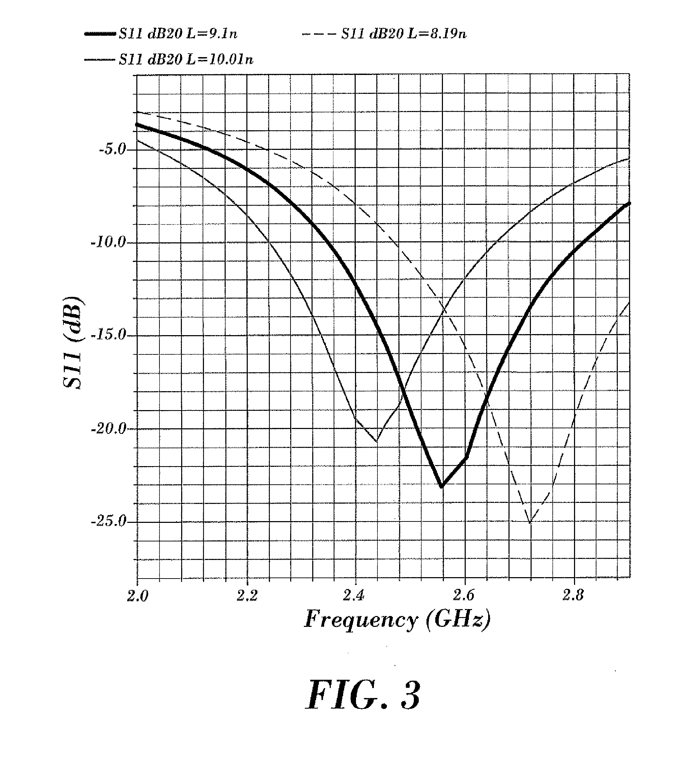

From the curves Figure 3, the impact of the ± 10% process variations of the gate inductor (3) is evaluated by measuring the input port voltage reflection coefficient (S11) values: the curve in black corresponds to S11 simulation when the input inductor of the LNA (100) takes a typical inductance value L = 9.1 nH; the curve in grey shows the S11 simulation when the input inductance (3) takes a value L = 10.01 nH corresponding to a process variation of +10%; and the curve in dots shows the S11 simulation when the input inductance (3) takes a value L = 8. 19 nH, that is, the process variation is -10%.

As can be observed, process variations on the gate inductor (3) seriously affects input matching of the LNA.

Table 1 summarizes an example of the capacitance values in the matching network structure formed by the four-diode structure (4) in order to adapt the shifts in frequency caused by process variation in the input inductor (3) shown in Figure 3. Table 1 indicates the required values of the capacitors Cin1 (110), Cin2 (210), Cin3 (120) and Cin4 (220) for different inductance values (L_{D}) of the gate inductor (3) of the LNA (100) in the circuit depicted in Figure 1.

**Table 1**

| **Process Variations** | **Typical** | **-10%** | | **+10%** | |
|---|---|---|---|---|---|
| **L_{D}** | **9.1 nH** | **8.19 nH** | | **10.01 nH** | |
| | C typical | C(L-10%) | ΔC(L-10%) | C(L+10%) | ΔC(L-10%) |
| **Cin1** | 487 fF | 657 fF | +170 fF | 457 fF | -30 fF |
| **Cin2** | 490 fF | 660 fF | +170 fF | 480 fF | -30 fF |
| **Cin3** | 80 fF | 120 fF | +40 fF | 45 fF | -35 fF |
| **Cin4** | 73 fF | 113 fF | +40 fF | 45 fF | -28 fF |

However, in order to be able to change the equivalent diode capacitances shown in Table 1, the circuit of Figure 1 is useless and need to be modified.

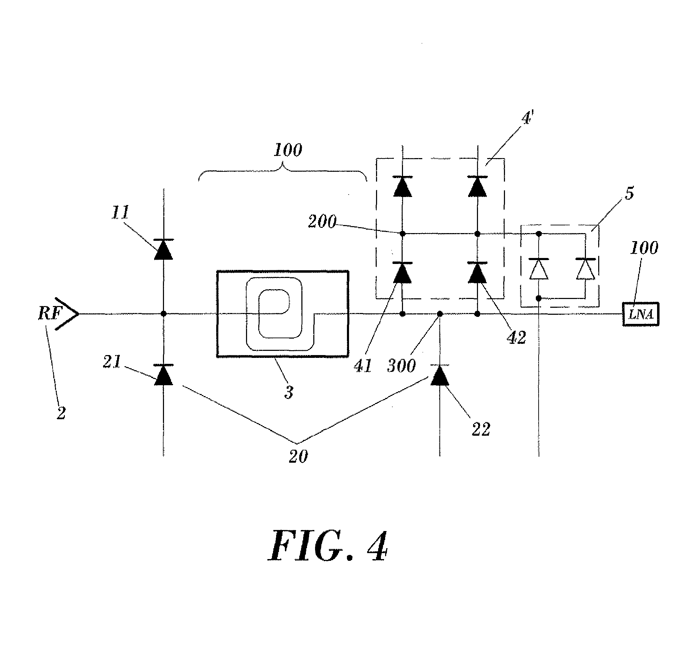

Figure 4 shows the modified architecture to control the calibration of the equivalent capacitance of the diode (12) by a variable biasing voltage (200) internally in the ESD circuitry, wherein the second diode (12) of the first ESD structure (10) has been replaced by an additional four-diode structure (4') with the same equivalent capacitance Cin3 (120). The additional four-diode structure (4') is applied, in the example of Figure 4, on the diode (12), but it can be applied on the first diode of structure (10) if required. The control or biasing voltage (200) is generated on the mid point of this additional four-diode structure (4'). Also, parasitic diodes (5) are included in order to better evaluate the real behavior of the invention. These two parasitic diodes (5) are due to the fact that two of the ESD diodes (41, 42) are connected between a signal point (300) and the control point to which the biasing voltage (200) is applied.

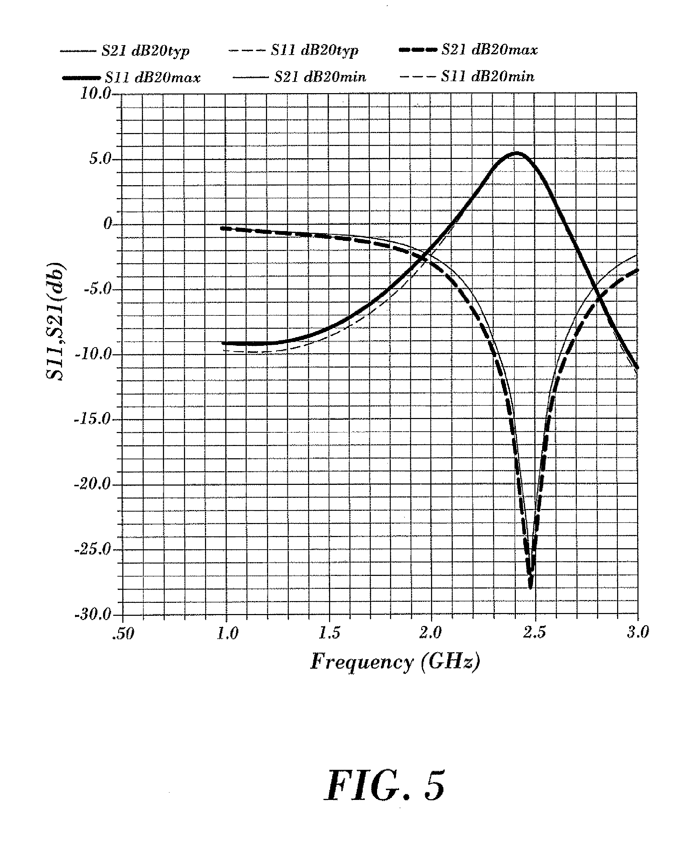

Figure 5 shows the compensated values of the forward voltage gain (S21) and the input port voltage reflection coefficient (S11) for a ±10% process variation of the input inductance value of the gate inductor (3) of the LNA (100).

As can be observed after application of the proposed methodology on the described circuit of Figure 4, ±10% process variation of the input inductance value of the gate inductor (3) of the LNA (100), can be successfully corrected, without degrading LNA performance.

In this text, the term "comprises" and its derivations (such as "comprising", etc.) should not be understood in an excluding sense, that is, these terms should not be interpreted as excluding the possibility that what is described and defined may include further elements, steps, etc.

On the other hand, the invention is obviously not limited to the specific embodiment(s) described herein, but also encompasses any variations that may be considered by any person skilled in the art (for example, as regards the choice of materials, dimensions, components, configuration, etc.), within the general scope of the invention as defined in the claims.

Some preferred embodiments of the invention are described in the dependent claims which are included next.

## Claims

1. Radio frequency circuit comprising a power rail ESD clamp circuit (1), a RF input (2), an inductor (3) from an LNA input (100) and **characterized by** further comprising a diodes structure for ESD protection and input impedance matching, and said diodes structure in turn comprises: a first ESD diodes structure (10) including a first diode (11) and an additional four-diode structure (4') having a mid point in which a biasing voltage (200) is applied to, and a second ESD diodes structure (20) forming together with the first diodes structure (10) and the inductor (3) a matching network to match the RF input (2) with the LNA input (100).

2. Radio frequency circuit according to claim 1, wherein the matching network is a Pi-matching network.

3. Radio frequency circuit according to any of claims 1-2, wherein the biasing voltage (200) on the ESD diodes is a DC voltage with a voltage level which is changed for calibration of the matching network connected to the LNA input (100).

4. Radio frequency circuit according to any preceding claim, wherein the first diodes structure (10) is formed by the first diode (11) having an equivalent capacitance Cᵢₙ₁ (110) connected to the additional four-diode structure (4'), which has an equivalent capacitance Cᵢₙ₃ (120), the additional four-diode structure (4') having a mid point in which the biasing voltage (200) is applied to.

5. Radio frequency circuit according to any of claims 1-3, wherein the second diodes structure (20) is formed by a third diode (21) with an equivalent capacitance Cᵢₙ₂ (210) and an additional four-diode structure (4') with an equivalent capacitance Cᵢₙ₄ (220), the additional four-diode structure (4') having a mid point in which the biasing voltage (200) is applied to.

6. Method for matching a radio frequency circuit comprising a passive network to match impedance from a radio frequency input (2), in which a radio frequency signal is applied to, and impedance from a low noise amplifier input (100), the matching network being formed by an input inductor (3) and a four-diode structure (4) connected between the radio frequency input (2) and the low noise amplifier input (100), the four-diode structure (4) consisting of a first ESD diodes structure (10) and a second ESD diodes structure (20) connected to the first diode structure (10) through the input inductor (3), **characterized by** comprising:
- replacing one of the diodes of the four-diode structure (4) by an additional four-diode structure (4') with an equivalent capacitance equal to equivalent capacitance of the replaced diode,
- generating a biasing voltage (200) applied to a mid point of the four-diode structure (4'),
- varying the biasing voltage (200), in order to tune the equivalent capacitance of the four-diode structure (4) together with the additional four-diode structure (4').
